# EUROPEAN PATENT APPLICATION

(11) **EP 4 696 972 A1**
(43) Date of publication of application: **18.02.2026**
(21) Application number: 25194631.5
(22) Date of filing: 07.08.2025
(51) Int. Cl.: F28F 9/02, H05K 7/20

(54) **MANIFOLD**

(30) Priority: 09.08.2024 TW 113208600 U
(71) Applicant: Cooler Master Co., Ltd., Taipei City 114065 (TW)
(72) Inventor: SU, YU-CHENG, 114065 Taipei City (TW); LIN, KENG-HAN, 114065 Taipei City (TW); CHEN, WEN-CHING, 114065 Taipei City (TW)
(74) Representative: Grünecker Patent- und Rechtsanwälte PartG mbB

(57) **Abstract**

Manifold comprises flow-splitting tube, two externally-connected tubes, and two covers. Flow-splitting tube has two flow paths which are not connected to each other, multiple flow-splitting ports and multiple confluence ports. The flow-splitting ports are connected to one flow path. The confluence ports are connected to the other flow path. The first externally-connected tube has a first externally-connected flow path connected to one flow path. The second externally-connected tube has a second externally-connected flow path connected to the other flow path. The first externally-connected tube and the second externally-connected tube are respectively fitted to two opposite sides of the flow-splitting tube. One cover is arranged at one side of the first externally-connected tube, and forms the first externally-connected flow path together with the first externally-connected tube. Another cover is arranged at one side of the second externally-connected tube, and forms the second externally-connected flow path together with the second externally-connected tube.

## Description

### TECHNICAL FIELD

The present disclosure relates to structures, such as a tube member, designed to collect, distribute, or combine fluids, and in particular relates to a structure and configuration of a manifold.

### BACKGROUND OF THE DISCLOSURE

With electronic devices emitting more and more heat, manufacturers keep introducing water-cooling systems of various kinds that are capable of cooling electronic devices effectively. In a water-cooling system, a manifold can be used to connect multiple pipeline components and is thus an indispensable fitting. Conventionally, a single-piece manifold is manufactured by a cutting process.

However, a single-piece manifold cutting process can take a long time and produce a large amount of waste. This increases the overall cost of manufacturing the manifold.

### SUMMARY OF THE DISCLOSURE

The invention is as defined in the appended claims. Exemplary embodiments of the present disclosure provide a manifold in which externally-connected tubes can be fitted to a flow-splitting tube, which can facilitate lower overall cost of manufacturing the manifold.

An example embodiment of the present disclosure provides a manifold comprising a flow-splitting tube, a first externally-connected tube, a second externally-connected tube, a first cover and a second cover. In an example implementation, the flow-splitting tube can have a first flow path and a second flow path which are not connected to each other, multiple flow-splitting ports and multiple confluence ports. The flow-splitting ports can be connected to the first flow path. The confluence ports can be connected to the second flow path. The first externally-connected tube can have a first externally-connected flow path connected to the first flow path. The second externally-connected tube can have a second externally-connected flow path connected to the second flow path. The first externally-connected tube and the second externally-connected tube can be respectively fitted to two opposite sides of the flow-splitting tube. The first cover can be arranged at one side of the first externally-connected tube, and can form the first externally-connected flow path together with the first externally-connected tube. The second cover can be arranged at one side of the second externally-connected tube, and can form the second externally-connected flow path together with the second externally-connected tube.

In an example implementation of a manifold according to disclosed example embodiment, the first externally-connected tube and the second externally-connected tube can be respectively fitted to two opposite sides of the flow-splitting tube. For example, in the disclosed example embodiment, the main structure forming the flow paths in the manifold can be split into at least two members.

Accordingly, for example and without limitation, a structural member with a simpler structure such as the flow-splitting tube can be manufactured by a simple and fast manufacturing process; and the complexity and duration of manufacturing processes of structural members with more complex structures, such as the first externally-connected tube and the second externally-connected tube, can be reduced due to a reduction in volume. Thus, for example and without limitation, there may be no need to use a complicated manufacturing process to manufacture a structurally complex manifold in a single operation, so the time taken to manufacture the manifold and the amount of waste produced can be reduced, thereby potentially greatly reducing the overall cost of manufacturing the manifold.

The above description of the summary of the present disclosure and the following description of the example embodiments are used to illustrate and explain the principles of the present disclosure, and can facilitate further understanding of the appended claims of the present disclosure

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
Fig. 1 is an illustrative 3D drawing of a manifold according to an example embodiment of the present disclosure.
Fig. 2 is an exploded diagrammatic view of a manifold according to an example embodiment such as in Fig. 1.
Fig. 3 is an illustrative 3D sectional schematic drawing of a manifold according to an example embodiment such as in Fig. 1.

### DETAILED DESCRIPTION OF EXEMPLARY EMBODIMENTS

Detailed features and advantages of embodiments of the present utility model are described in detail below in embodiments, the content of which is sufficient to allow any person skilled in the art to understand and thereby implement the technical content of embodiments of the present utility model, and any person skilled in the art can readily understand the relevant objectives and advantages of the present utility model on the basis of the content disclosed herein, the claims and the drawings. The embodiments below describe the viewpoints of the present utility model in further detail, but none of these viewpoints limits the scope of the present utility model. Accordingly, those of ordinary skill in the art will recognize that various changes and modifications of the embodiments described herein can be made without departing from the scope and spirit of the described disclosure. Also, descriptions of well-known functions and constructions are omitted for clarity and conciseness.

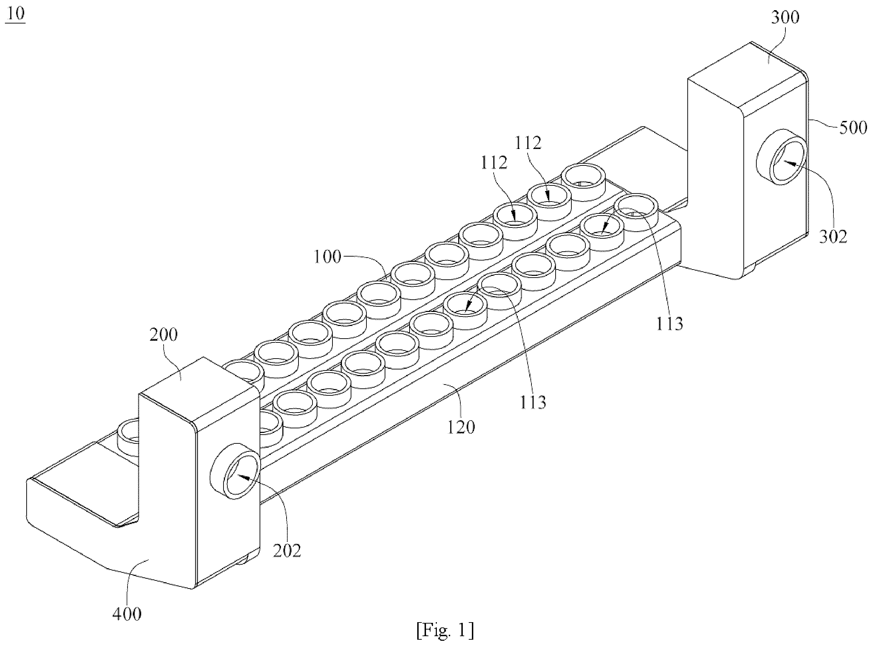

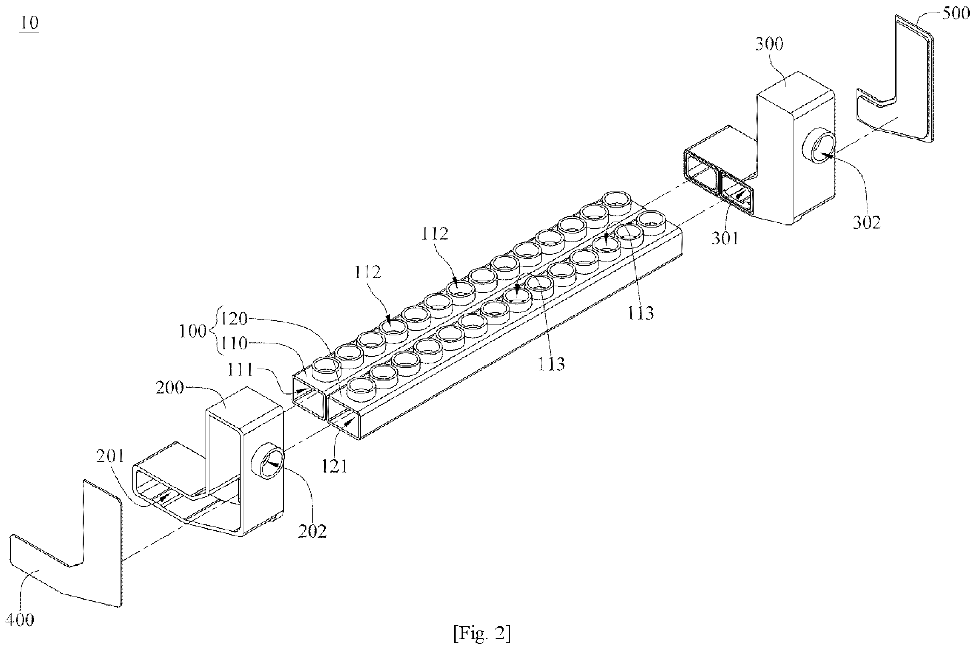

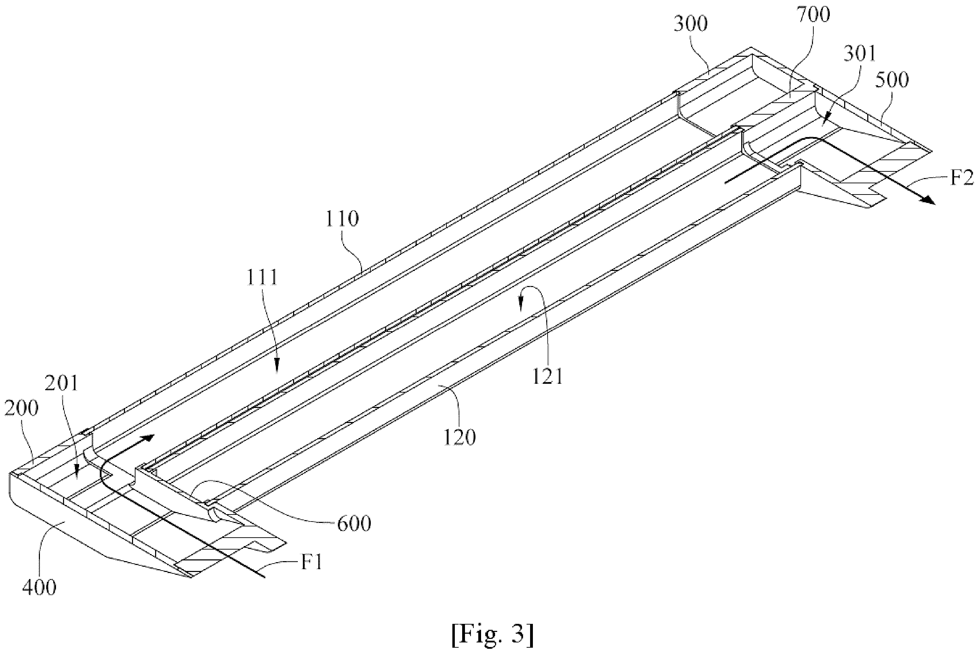

Referring to exemplary illustrations of Figs. 1 - 3. Fig. 1 is an illustrative 3D drawing (or a perspective view) of a manifold according to an example embodiment of the present disclosure. Fig. 2 is an illustrative exploded drawing of an example implementation of a manifold such as in example embodiment illustrated in Fig. 1. Fig. 3 is an illustrative 3D sectional schematic drawing of an example implementation of a manifold such as in example embodiment illustrated in Fig. 1.

In an example embodiment, the manifold 10 can comprise a flow-splitting tube 100, a first externally-connected tube 200, a second externally-connected tube 300, a first cover 400, a second cover 500, a first partition 600 and a second partition 700.

In an example implementation of example embodiment, the flow-splitting tube 100 for example comprises a first flow-splitting tube 110 and a second flow-splitting tube 120, arranged side by side. The first flow-splitting tube 110 can have a first flow path 111 and multiple flow-splitting ports 112. The flow-splitting ports 112 can be connected to the first flow path 111. The second flow-splitting tube 120 can have a second flow path 121 and multiple confluence ports 122. The confluence ports 122 can be connected to the second flow path 121. The first flow path 111 and the second flow path 121 are not connected to each other. In such an example implementation of disclosed embodiment, the first flow-splitting tube 110 and the second flow-splitting tube 120 can be formed by extrusion. For example, material can be first pushed into a die, so that all of the extruded material in the form of a strip has the same cross-sectional shape, so as to form the first flow-splitting tube 110 and the second flow-splitting tube 120. However, in an exemplary implementation, the first flow-splitting tube 110 and the second flow-splitting tube 120 could instead be formed by drawing, i.e. by pulling material out of a die. It should be noted that in other example embodiments, the flow-splitting tube could also be a single-piece flow tube with two independent flow paths which are not connected to each other.

In an exemplary implementation, the first externally-connected tube 200 can have a first externally-connected flow path 201 and an inflow port 202. The inflow port 202 can be connected to the first externally-connected flow path 201. The first externally-connected flow path 201 can be connected to the first flow path 111.

In a further exemplary implementation, the second externally-connected tube 300 can have a second externally-connected flow path 301 and an outflow port 302. The outflow port 302 can be connected to the second externally-connected flow path 301. The second externally-connected flow path 301 can be connected to the second flow path 121.

In still further exemplary implementation, the first externally-connected tube 200 and the second externally-connected tube 300 can be, for example, respectively fitted to two opposite sides of the first flow-splitting tube 110 and the second flow-splitting tube 120 by welding.

In yet further exemplary implementation, the first externally-connected tube 200 and the second externally-connected tube 300 can be, for example, formed by forging and cutting.

In an example embodiment, the cross-sectional shapes of the first flow-splitting tube 110 and the second flow-splitting tube 120 can be, for example, different from the cross-sectional shapes of the first externally-connected tube 200 and the second externally-connected tube 300. In an example implementation of the example embodiment, the cross sections of the first externally-connected tube 200 and the second externally-connected tube 300 can be, for example, L-shaped, and the cross sections of the first flow-splitting tube 110 and the second flow-splitting tube 120 can be, for example, square. However, example embodiments of the present disclosure are not limited to such configurations. In other example embodiments, or example implementation, the first flow-splitting tube, the second flow-splitting tube, the first externally-connected tube and the second externally-connected tube may also have the same cross-sectional shapes.

In an example implementation, the first cover 400 can be arranged at one side of the first externally-connected tube 200, forming the first externally-connected flow path 201 together with the first externally-connected tube 200. The second cover 500 can be arranged at one side of the second externally-connected tube 300, forming the second externally-connected flow path 301 together with the second externally-connected tube 300.

In a further example implementation, the first partition 600 can be arranged in the first externally-connected tube 200, such that the first externally-connected flow path 201 is not connected to the second flow path 121. The second partition 700 can be arranged in the second externally-connected tube 300, such that the second externally-connected flow path 301 is not connected to the first flow path 111.

As shown in the illustrative examples of Figs. 1 and 3, in an example implementation, after a working liquid such as water flows into the first externally-connected flow path 201 through the inflow port 202, the working fluid will be blocked by the first partition 600 and flow in a flow direction F1 to the first flow path 111, and then flow out of the manifold 10 through the flow-splitting ports 112. The working fluid flowing out of the manifold 10 may, for example, flow into a pipeline of an electronic device, and then flow into the second flow path 121 through the confluence ports 122. In an example implementation, the working fluid flowing into the second flow path 121 will be blocked by the second partition 700 and flow in a flow direction F2 to the second externally-connected flow path 301, and then flow out of the manifold 10 through the outflow port 302.

In a manifold according to example disclosed embodiment, the first externally-connected tube and the second externally-connected tube can be respectively fitted to two opposite sides of the flow-splitting tube. In example implementations of example disclosed embodiments, the main structure forming the flow paths in the manifold can be split into at least two members. Thus, according to example implementations and without limitations, a structural member with a simpler structure such as the flow-splitting tube can be manufactured by a simple and fast manufacturing process; and the complexity and duration of manufacturing processes of structural members with more complex structures, such as the first externally-connected tube and the second externally-connected tube, can be reduced due to a reduction in volume. Thus, according to example implementations and without limitations, there may be no need to use a complicated manufacturing process to manufacture a structurally complex manifold in a single operation, so the time taken to manufacture the manifold and the amount of waste produced can be reduced, thereby greatly reducing the overall cost of manufacturing a manifold.

In further example implementations of example embodiments, the cross sections of the first externally-connected tube and the second externally-connected tube can be, for example, designed to be L-shaped, and thus have complex shapes. According to such example implementations, the method of having the first externally-connected tube and the second externally-connected tube respectively fitted to two opposite sides of the flow-splitting tube of example embodiments can be implemented to, for example and without limitation, more significantly reduce the overall cost of manufacturing a manifold.

The above-presented description and figures are intended by way of example only and are not intended to limit the illustrative embodiments in any way except as set forth in the appended claims. It is particularly noted that various technical aspects of the various elements of the various exemplary embodiments that have been described above can be combined in numerous other ways, all of which are considered to be within the scope of the disclosure.

Accordingly, although exemplary implementations of example embodiment have been disclosed, these are not intended to limit the present disclosure, and any person skilled in the art may make changes and modifications without departing from the scope of theclaims. Therefore, the scope of patent protection of the present disclosure shall be as defined by the scope of the claims appended to this description and equivalents thereof.

The terms and corresponding labels referenced in the disclosure are listed below for convenience. As would be readily appreciated by skilled artisans in the relevant art, while these and other descriptive terms are used throughout this specification to facilitate understanding, it is not intended to limit any components that can be used in combinations or individually to implement various aspects of the embodiments of the present disclosure.
10: manifold
100: flow-splitting tube
110: first flow-splitting tube
111: first flow path
112: flow-splitting port
120: second flow-splitting tube
121: second flow path
122: confluence port
200: first externally-connected tube
201: first externally-connected flow path
202: inflow port
300: second externally-connected tube
301: second externally-connected flow path
302: outflow port
400: first cover
500: second cover
600: first partition
700: second partition
F1, F2: flow directions

## Claims

1. A manifold (10) comprising:
a flow-splitting tube (100) comprising
a first flow path (111),
a second flow path (121) not connected to said first flow path (111),
a plurality of flow-splitting ports (112) connected to the first flow path (111), and
a plurality of confluence ports (122) connected to the second flow path (121);
a first externally-connected tube (200) comprising a first externally-connected flow path (201) connected to the first flow path (111), the first externally-connected tube (200) being fitted to a first side of the flow-splitting tube (100);
a second externally-connected tube (300) comprising a second externally-connected flow path (301) connected to the second flow path (121), the second externally-connected tube (300) being fitted to a second side of the flow-splitting tube (100) opposite the first side of the flow-splitting tube (100);
a first cover (400) arranged at one side of the first externally-connected tube (200), and
forming the first externally-connected flow path (201) together with the first externally-connected tube (200); and
a second cover (500), arranged at one side of the second externally-connected tube (300), and
forming the second externally-connected flow path (301) together with the second externally-connected tube (300).

2. The manifold (10) as claimed in claim 1, wherein the flow-splitting tube (100) comprises a first flow-splitting tube (110) and a second flow-splitting tube (120) arranged side by side, the first flow path (111) and the flow-splitting ports (112) being located on the first flow-splitting tube (110), and the second flow path (121) and the confluence ports (122) being located on the second flow-splitting tube (120).

3. The manifold (10) as claimed in claim 2, wherein cross-sectional shapes of the first flow-splitting tube (110) and the second flow-splitting tube (120) are different from cross-sectional shapes of the first externally-connected tube (200) and the second externally-connected tube (300).

4. The manifold (10) as claimed in claim 3, wherein the first externally-connected tube (200) and the second externally-connected tube (300) have L-shaped cross sections.

5. The manifold (10) as claimed in claim 3, wherein the first flow-splitting tube (110) and the second flow-splitting tube (120) have square cross sections.

6. The manifold (10) as claimed in claim 2, wherein the first flow-splitting tube (110) and the second flow-splitting tube (120) are formed by extrusion.

7. The manifold (10) as claimed in claim 1, wherein the first externally-connected tube (200) and the second externally-connected tube (300) are fitted to the flow-splitting tube (100) by welding.

8. The manifold (10) as claimed in claim 1, further comprising a first partition (600), arranged in the first externally-connected tube (200) such that the first externally-connected flow path (201) is not connected to the second flow path (121).

9. The manifold (10) as claimed in claim 8, further comprising a second partition (700), arranged in the second externally-connected tube (300) such that the second externally-connected flow path (301) is not connected to the first flow path (111).

10. The manifold (10) as claimed in claim 1, wherein the first externally-connected tube (200) and the second externally-connected tube (300) are formed by forging and cutting.
